# EUROPÄISCHE PATENTSCHRIFT

(11) **EP 1 153 310 B1**
(45) Veröffentlichungstag und Bekanntmachung des Hinweises auf die Patenterteilung: **21.05.2003**
(21) Anmeldenummer: 00904880.2
(22) Anmeldetag: 07.01.2000
(51) Int. Cl.: G01R 31/36

(54) **VERFAHREN ZUR BESTIMMUNG EINES LADUNGSZUSTANDS EINER BATTERIE**
METHOD FOR DETERMINING A STATE OF CHARGE OF A BATTERY
PROCEDE POUR DETERMINER L'ETAT DE CHARGE D'UNE BATTERIE

(30) Priorität: 11.02.1999 DE 19905550
(43) Veröffentlichungstag der Anmeldung: 14.11.2001
(73) Patentinhaber: Braun GmbH, 61476 Kronberg (DE)
(72) Erfinder: FRANKE, Michael, D-64291 Darmstadt (DE)
(86) Internationale Anmeldenummer: EP0000063
(87) Internationale Veröffentlichungsnummer: WO00048013

(56) Entgegenhaltungen:
- DE-A- 4 437 647
- US-A- 5 287 286
- US-A- 5 804 894

## Beschreibung

Die Erfindung betrifft ein Verfahren zur Bestimmung bzw. Anzeige des Zustands einer Primär- oder Sekundärbatterie, in dem diese bis auf eine Mindestrestladung entladen ist.

Aus der DE 41 31 981 A1 sind zwei Varianten eines mit einer wiederaufladbaren Batterie betreibbaren elektrischen Geräts bekannt, die beide eine Ladezustandsanzeige aufweisen. Bei der ersten Variante erfolgt die Anzeige des Ladezustands lediglich anhand der durch einen Zähler gemessenen Zeit, während der das Gerät an die Batterie angeschlossen war. Diese Anzeige liefert nur dann genaue Werte, wenn der Stromverbrauch des Geräts und die Kapazität der Batterie konstant sind. Bei der zweiten Variante wird die Ladezustandsanzeige durch einen Zähler und einen Spannungsdiskriminator gesteuert, der einen bestimmten Schwellwert der Batteriespannung detektiert. Die Anzeige des Ladezustands erfolgt solange ebenfalls anhand der durch den Zähler gemes- senen Zeit, bis die Batteriespannung auf die Schwellwertspannung abgesunken ist. Danach wird jedoch ein Zähler gestartet, der eine bestimmte Restbetriebszeit vorgibt, die ebenfalls angezeigt wird. Bei fortgeschrittener Alterung der Batterie und/oder ausgeprägtem Memory-Effekt zeigt diese Anzeige bereits dann "Null" an, wenn das Gerät mit der noch vorhandenen Restladung eine gewisse Zeit weiterbetrieben werden könnte.

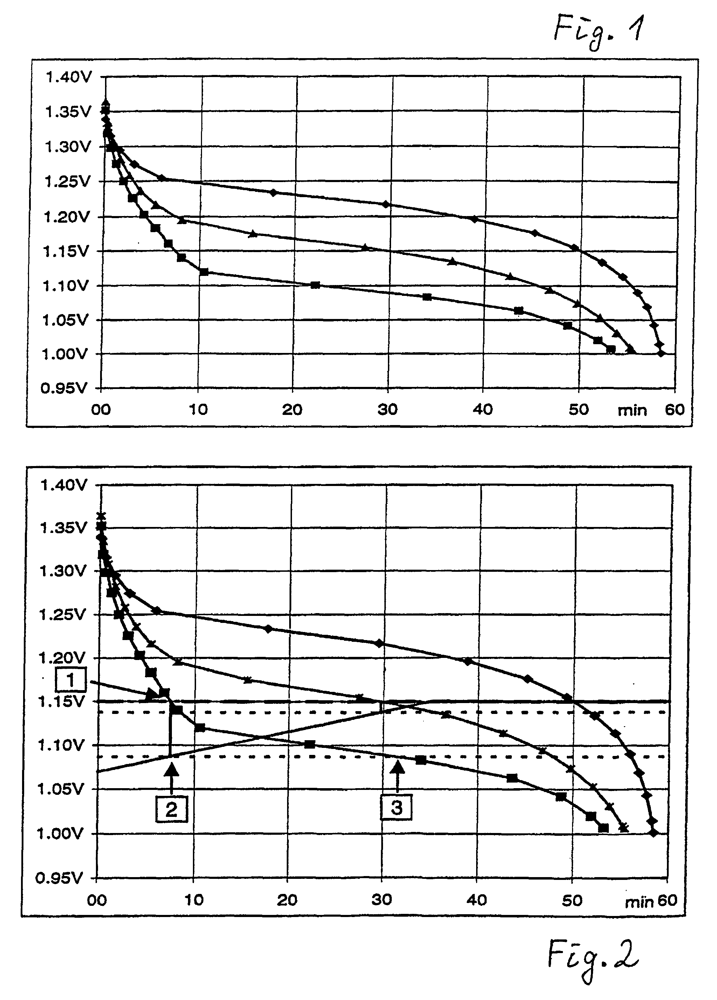

Die durch Alterung und Memory-Effekt bedingten Änderungen der Batterieeigenschaften werden nachfolgend beispielhaft anhand von Fig. 1 erläutert, in der typische Entladekennlinien einer wiederaufladbaren Batterie dargestellt sind. Die oberste Kurve zeigt den zeitabhängigen Verlauf der Batteriespannung einer neuen Batterie, die ausgehend vom voll aufgeladenen Zustand (Spannung 1,35 V) über einen Zeitraum von 50 Minuten vollständig entladen wird (Spannung <1 V). Betreibt man die Batterie mehrere Jahre lang in einer Weise, bei der sie immer nur wenige Minuten entladen und danach wieder voll aufgeladen wird, so ergibt sich bei einer dann vorgenommenen vollständigen Entladung der Batterie die unterste in Fig. 1 dargestellte Kurve. Wird die Batterie daraufhin mehrmals voll aufgeladen und wieder vollständig entladen, so erhält man schließlich die mittlere in Fig. 1 dargestellte Kurve. Der Unterschied zwischen der obersten und der mittleren Kurve ist auf Alterung zurückzuführen, wogegen der Unterschied zwischen der untersten und der mittleren Kurve durch den Memory-Effekt bedingt ist.

Die Entladekennlinien nicht wiederaufladbarer Batterien verschiedener Hersteller unterschieden sich ebenfalls auf eine Art, die sich ähnlich wie in Fig. 1 darstellen läßt, auch wenn es sich um jeweils denselben Batterietyp und dieselbe Batteriegröße handelt.

Aus der DE 44 37 647 A1 ist ein Verfahren bekannt, das ausgehend von dem aus der oben genannten DE 41 31 981 A1 entnehmbaren Verfahren eine genauere Anzeige des "low charge" Zustands einer wiederaufladbaren Batterie ermöglicht, da es die mit der Zeit auftretende Änderung deren Eigenschaften berücksichtigt. Unter "low charge" Zustand soll der Zustand verstanden werden, bei dem die Batterie bis auf eine bestimmte Restladung entladen ist. Dazu wird durch einen Zähler die Zeit gemessen, die vergeht, bis die Batterie über einen angeschlossenen Verbraucher soweit entladen ist, daß ihre Spannung bis auf eine "low charge" Spannung abgesunken ist Ist diese Zeit kürzer als eine vorgegebene Mindestzeit, wird bei einer ersten Variante erst nach Verstreichen der Mindestzeit eine Anzeige für den "low charge" Zustand aktiviert. Bei einer weiteren Variante wird, sofern diese Mindestzeit beispielsweise erstmals nach mehreren Jahren der Benutzung des Geräts unterschritten wird, die "low charge" Spannung um einen bestimmten Betrag erniedrigt, und erst bei Erreichen der erniedrigten "low charge" Spannung die "low charge" Anzeige aktiviert. Auf diese Weise wird die Anzeige des "low charge" Zustands an die Veränderung der Batterieeigenschaften jedoch nur relativ grob angepaßt.

Aus der US 5287286 ist ein Verfahren zur Erkennung des entladenen Zustands einer Batterie bekannt. Der entladene Zustand wird durch einen Rechner ermittelt, der drei Parameter kombiniert, nämlich die gemessene Batteriespannung, den gemessenen Batteriestrom und Batteriespannungsänderungen. Im Rechner sind zwei Tabellen gespeichert. Aus der ersten Tabelle wird abhängig vom gemessenen Strom eine Referenzspannung ausgelesen, die als Indikator für eine leere Batterie angesehen wird. Ferner wird die Batteriespannung fortlaufend gemessen und die Zeit ermittelt, die verstreicht, bis die Batteriespannung um 59 mV gesunken ist. Anhand der ermittelten Zeit wird dann aus der zweiten Tabelle ein Korrekturwert für die Referenzspannung ausgelesen. Durch Vergleich der Batteriespannung mit der korrigierten Referenzspannung wird dann festgestellt, ob der entladene Zustand erreicht ist oder nicht.

Es ist Aufgabe der vorliegenden Erfindung, ein Verfahren zur Bestimmung des Zustands einer Batterie anzugeben, in dem diese bis auf eine Mindestrestladung entladen ist, das mit minimalem Aufwand realisiert werden kann, herstellerunabhängig und trotz Alterung und/oder Memory-Effekt der Batterie hinreichend genau ist.

Diese Aufgabe wird durch das im Anspruch 1 angegeben Verfahren zur Bestimmung des Zustands einer wiederaufladbaren oder nichtwiederaufladbaren Batterie, in dem diese bis auf eine Restladung entladen ist, gelöst, d.h. erfindungsgemäß wird nach Volladung oder Austausch der Batterie die Zeit gemessen, bis die Batteriespannung auf einen ersten Spannungsschwellwert abgesunken ist, dann wird der erste Spannungsschwellwert um einen von der gemessenen Entladezeit abhängigen Betrag erniedrigt, und erst das Absinken der Batteriespannung auf den erniedrigten Spannungsschwellwert wird als Indikator für die Entladung der Batterie auf die Restladung angesehen.

Beim erfindungsgemäßen Verfahren wird nach vollständiger Aufladung der wiederaufladbaren Batterie die Zeit gemessen, die vergeht, bis die Batterie über einen angeschlossenen Verbraucher soweit entladen ist, daß die Batteriespannung bis auf einen ersten Spannungsschwellwert abgesunken ist. Dabei wird davon ausgegangen, daß der Verbraucher eine im zeitlichen Mittel im wesentlichen konstante Stromaufnahme besitzt. Nach Erreichen des ersten Spannungsschwellwerts wird dieser um einen von der gemessenen Entladezeit abhängigen Betrag erniedrigt. Wenn die Batterie über den Verbraucher weiter entladen wird, sodaß die Batteriespannung noch weiter absinkt, wird das Erreichen des erniedrigten Spannungsschwellwerts als Indikator für die Entladung der Batterie auf eine bestimmte Restladung, d.h. das Vorliegen eines sogenannten "low charge" Zustands der Batterie, angesehen. Das Erreichen des "low charge" Zustands kann durch eine entsprechende Anzeigevorrichtung angezeigt werden. Nach Erreichen des "low charge" Zustands kann der Verbraucher mit der dann noch gespeicherten Restladung eine bestimmte Mindestzeit, beispielsweise einige Minuten, betrieben werden. Auf diese Weise wird ein Benutzer eines den Verbraucher enthaltenden Geräts, beispielsweise eines elektrischen Rasierers oder einer elektrischen Zahnbürste, rechtzeitig darauf hingewiesen, daß die Batterie des Geräts wieder aufgeladen werden muß.

In der Praxis kann der Fall auftreten, daß bei Entladung der Batterie über einen angeschlossenen Verbraucher die Batteriespannung mehrmals die dem ersten Spannungsschwellwert entsprechende Spannung annimmt. Wird nämlich der Verbraucher abgeschaltet, kurz nachdem die Batteriespannung den ersten Spannungsschwellwert unterschritten hat, erholt sich die Batterie, und ihre Spannung steigt ggfs. auf einen Wert an, der größer ist als der erste Spannungsschwellwert. Wird der Verbraucher danach wieder eingeschaltet, sinkt die Batteriespannung erneut von einem Wert, der größer ist als der erste Spannungsschwellwert, auf einen Wert, der kleiner ist als der erste Spannungsschwellwert. Damit die Bestimmung der Restladung durch solche Abläufe nicht verfälscht werden kann, wird beim erfindungsgemäßen Verfahren nach Volladung der wiederaufladbaren Batterie vorzugsweise nur beim erstmaligen Erreichen des ersten Spannungsschwellwerts dieser erniedrigt.

Eine besonders gute Anpassung des erfindungsgemäßen Verfahrens an typische Batterieeigenschaften erreicht man, wenn der Betrag, um den der erste Spannungsschwellwert erniedrigt wird, um so größer ist, je kleiner die gemessene Entladezeit ist. Bei einer neuen oder fast neuen wiederaufladbaren Batterie überschreitet die gemessene Entladezeit eine bestimmte Maximalzeit. In diesem Fall kann auf eine Erniedrigung des ersten Spannungsschwellwerts verzichtet werden.

Wird die wiederaufladbare Batterie teilweise wieder aufgeladen, bevor die Batteriespannung erstmalig auf den ersten Spannungsschwellwert abgesunken war, so wird die gemessene Entladezeit um einen der zugeführten Ladung entsprechenden Betrag verringert. Wird die Batterie teilweise wieder aufgeladen, nachdem der Spannungsschwellwert bereits erniedrigt wurde, wird der erniedrigte Spannungsschwellwert solange beibehalten, bis die Batterie wieder vollständig aufgeladen wurde. Nach vollständiger Aufladung der wiederaufladbaren Batterie oder Austausch der wiederaufladbaren Batterie wird die gemessene Entladezeit auf "Null" und der erniedrigte Spannungsschwellwert auf den ersten Spannungsschwellwert zurückgesetzt.

Bei einer nicht wiederaufladbaren Batterie ist das oben beschriebene erfindungsgemäße Verfahren in gleicher Weise anwendbar. Allerdings beginnt die Zeitmessung nicht nach dem Volladen sondern beim Neuzustand der Batterie bzw. einem Austausch einer leeren gegen eine volle Batterie. Auf diese Weise kann bei jeder Batterie, egal von welchem Hersteller sie stammt, die gespeicherte Ladung weitestgehend ausgenutzt werden.

Die Erfindung wird nachstehend anhand eines Ausführungsbeispiels erläutert, das in den Zeichnungen dargestellt ist. Weitere Varianten sind in der Beschreibung beschrieben. Es zeigt:
- Fig. 1: an sich bekannte Entladungskurven einer wiederaufladbaren Batterie;
- Fig. 2: eine graphische Veranschaulichung des erfindungsgemäßen Verfahrens.

Die in Fig. 2 dargestellten Entladekurven entsprechen den bereits aus Fig. 1 bekannten Kurven. Zusätzlich sind jedoch in Fig. 2 der erste Spannungsschwellwert, die zu der untersten und der mittleren Kurve gehörenden erniedrigten Spannungsschwellwerte und der Betrag eingezeichnet, um den jeweils der erste Spannungsschwellwert erniedrigt wird. Ferner ist auch die Abhängigkeit des Betrags der Erniedrigung von der gemessenen Entladezeit dargestellt.

Bei dem Beispiel gemäß Fig. 2 beträgt der erste Spannungsschwellwert 1,15V. Er ist durch eine horizontal verlaufende gestrichelte Linie dargestellt. An den Schnittpunkten der untersten und mittleren Entladekurve mit dem ersten Spannungsschwellwert sind die Beträge, um die der erste Spannungsschwellwert erniedrigt wird, als vertikal nach unten verlaufende ausgezogene Linien dargestellt. Am unteren Ende dieser Linien sind die erniedrigten Spannungsschwellwerte als horizontal verlaufende gepunktete Linien dargestellt. Eine geneigt verlaufende Gerade zeigt an, daß der Betrag, um den der erste Spannungsschwellwert erniedrigt wird, um so größer ist, je kleiner die gemessene Entladezeit ist. Ferner ist ersichtlich, daß bei diesem Beispiel der erste Spannungsschwellwert überhaupt nicht erniedrigt wird, wenn die gemessene Entladezeit größer ist als etwa 35 Minuten.

Der Ablauf des erfindungsgemäßen Verfahrens ist in Fig. 2 durch die Zahlen 1, 2 und 3 verdeutlicht, die am Beispiel der untersten Kurve das Absinken der Batteriespannung bzw. das Erreichen des ersten Spannungsschwellwerts, die Erniedrigung des Spannungsschwellwerts von 1,15V auf ca. 1,08V und das Erreichen des erniedrigten Spannungsschwellwerts bzw. die Anzeige des "low charge" Zustands symbolisieren.

Bei einem in den Figuren nicht dargestellten anderen Beispiel besteht eine nichtlineare Abhängigkeit des Betrags der Erniedrigung von der gemessenen Entladezeit.

Der "low charge" Zustand kann durch eine an sich bekannte optische, akustische oder haptische Anzeigevorrichtung angezeigt werden.

## Patentansprüche

1. Verfahren zur Bestimmung des Zustands einer wiederaufladbaren oder nichtwiederaufladbaren Batterie, in dem diese bis auf eine Restladung entladen ist, **dadurch gekennzeichnet, daß** nach Volladung oder Austausch der Batterie die Entladezeit gemessen wird, bis die Batteriespannung auf einen ersten Spannungsschwellwert abgesunken ist, daß dann der erste Spannungsschwellwert um einen von der gemessenen Entladezeit abhängigen Betrag erniedrigt wird, und daß erst das Absinken der Batteriespannung auf den erniedrigten Spannungsschwellwert als Indikator für die Entladung der Batterie auf die Restladung angesehen wird.

2. Verfahren nach Anspruch 1, **dadurch gekennzeichnet,**
**daß** nach jeder Volladung bzw. jedem Austausch nur beim erstmaligem Absinken der Batteriespannung auf den ersten Spannungsschwellwert dieser erniedrigt wird.

3. Verfahren nach Anspruch 1 oder 2, **dadurch gekennzeichnet,**
**daß** der erste Spannungsschwellwert um einen um so größeren Betrag erniedrigt wird, je kürzer die gemessene Entladezeit ist.

4. Verfahren nach einem der vorhergehenden Ansprüche, **dadurch gekennzeichnet, daß** der erste Spannungsschwellwert nicht erniedrigt wird, wenn die gemessene Entladezeit eine bestimmte Maximalzeit überschreitet.

5. Verfahren nach einem der vorhergehenden Ansprüche, **dadurch gekennzeichnet, daß** das Absinken der Batteriespannung auf die Spannung des erniedrigten Spannungsschwellwerts durch eine Anzeigevorrichtung angezeigt wird.

6. Verfahren nach einem der vorhergehenden Ansprüche, **dadurch gekennzeichnet, daß** nach Volladung oder Austausch der Batterie die gemessene Entladezeit auf "Null" und der erniedrigte Spannungsschwellwert auf den ersten Spannungsschwellwert zurückgesetzt wird.

7. Verfahren nach einem der vorhergehenden Ansprüche, **dadurch gekennzeichnet, daß** bei einer wieder aufladbaren Batterie die gemessene Entladezeit um einen der zugeführten Ladung entsprechenden Betrag verringert wird, wenn die wieder aufladbare Batterie teilweise aufgeladen wurde, bevor die Batteriespannung erstmalig auf den ersten Spannungsschwellwert abgesunken war.

## Claims

1. A method for determining the status of a rechargeable or non-rechargeable battery in which said battery is discharged to a residual charge, **characterized by** the steps of measuring, following a full charge or replacement of the battery, the time which elapses until the battery voltage has dropped to a first voltage threshold value, then lowering the first voltage threshold value by an amount dependent on the measured discharge time, and taking the dropping of the battery voltage to the lowered voltage threshold value as an indicator for battery's discharge to the residual charge.

2. The method as claimed in claim 1, **characterized by** the step of lowering, after each full charge or each replacement, the first voltage threshold value only when the battery voltage drops to said value for the first time.

3. The method as claimed in claim 1 or 2, **characterized by** the step of lowering the first voltage threshold value by an amount which is the greater the shorter the measured discharge time.

4. The method as claimed in any one of the preceding claims, **characterized by** the step of not lowering the first voltage threshold value if the measured discharge time exceeds a specific maximum time.

5. The method as claimed in any one of the preceding claims, **characterized by** the step of indicating the lowering of the battery voltage to the voltage of the lowered voltage threshold value by means of an indicating device.

6. The method as claimed in any one of the preceding claims, **characterized by** the step of resetting, after fully charging or replacing the battery, the measured discharge time to "zero" and resetting the lowered voltage threshold value to the first voltage threshold value.

7. The method as claimed in any one of the preceding claims, **characterized by** the step of reducing, in a rechargeable battery, the measured discharge time by an amount corresponding to the supplied charge, if the rechargeable battery is partly recharged before the battery voltage has dropped to the first voltage threshold value for the first time.

## Revendications

1. Procédé pour déterminer l'état de charge d'une batterie rechargeable ou non rechargeable, selon lequel cette batterie est déchargée jusqu'à posséder une charge résiduelle, **caractérisé en ce qu'**après la pleine charge ou le remplacement de la batterie, on mesure la durée de décharge jusqu'à ce que la tension de la batterie soit tombée à une première valeur de seuil de tension, qu'ensuite on réduit la première valeur de seuil de tension d'une valeur qui dépend de la durée de décharge mesurée et que l'on considère uniquement l'abaissement de la tension de la batterie à une valeur de seuil de tension réduite comme indicateur de la décharge de la batterie fournissant la chaleur résiduelle.

2. Procédé selon la revendication 1, **caractérisé en ce qu'**après la pleine charge ou après chaque remplacement, c'est seulement lorsque pour la première fois la tension de la batterie tombe à la première valeur de seuil de tension, que cette dernière est réduite.

3. Procédé selon la revendication 1 ou 2, **caractérisé en ce qu'**on réduit la première valeur de seuil de la tension d'une valeur d'autant plus grande que la durée de décharge mesurée est courte.

4. Procédé selon l'une des revendications précédentes, **caractérisé en ce que** la première valeur de seuil de tension n'est pas réduite lorsque la durée de décharge mesurée dépasse une durée maximale déterminée.

5. Procédé selon l'une des revendications précédentes, **caractérisé en ce que** l'abaissement de la tension de la batterie à la tension de la valeur de seuil de tension réduite est affiché par un dispositif d'affichage.

6. Procédé selon l'une des revendications précédentes, **caractérisé en ce qu'**après la décharge complète ou un remplacement de la batterie, la durée de décharge mesurée est ramenée à "zéro" et que la valeur de seuil réduite de la tension est ramenée à la première valeur de seuil de tension.

7. Procédé selon l'une des revendications précédentes, **caractérisé en ce que** dans le cas d'une batterie rechargeable, la durée de décharge mesurée est réduite d'une valeur qui correspond à la charge appliquée, lorsque la batterie rechargeable a été partiellement chargée, avant que la tension de la batterie soit tombée pour la première fois à la première valeur de seuil de tension.
